# EUROPÄISCHE PATENTSCHRIFT

(11) **EP 0 920 655 B1**
(45) Veröffentlichungstag und Bekanntmachung des Hinweises auf die Patenterteilung: **20.09.2000**
(21) Anmeldenummer: 97944783.6
(22) Anmeldetag: 22.08.1997
(51) Int. Cl.: G03F 7/32, G03F 7/09, G03F 7/38

(54) **BÄDER ZUR ERZEUGUNG VON MIKROSTRUKTUREN**
BATHS FOR PRODUCING MICROSTRUCTURES
BAINS POUR PRODUIRE DES MICROSTRUCTURES

(30) Priorität: 23.08.1996 DE 19634122
(43) Veröffentlichungstag der Anmeldung: 09.06.1999
(73) Patentinhaber: Clondiag Chip Technologies GmbH, 07743 Jena (DE)
(72) Erfinder: ERMANTRAUT, Eugen, D-07745 Jena (DE); WOHLFART, Klaus, D-07751 Laasan (DE); KÖHLER, Johann, Michael, D-07751 Golmsdorf (DE); SCHULZ, Torsten, D-07743 Jena (DE)
(74) Vertreter: Pfeiffer, Rolf-Gerd, Dipl.-Phys.
(86) Internationale Anmeldenummer: EP9704589
(87) Internationale Veröffentlichungsnummer: WO9808145

(56) Entgegenhaltungen:
- DE-A- 2 253 944
- DE-C- 4 024 748
- GB-A- 1 202 592
- PATENT ABSTRACTS OF JAPAN vol. 005, no. 009 (P-045), 21.Januar 1981 & JP 55 138741 A (CANON INC), 29.Oktober 1980,
- PATENT ABSTRACTS OF JAPAN vol. 010, no. 102 (P-448), 18.April 1986 & JP 60 235132 A (MITSUBISHI DENKI KK), 21.November 1985,

## Beschreibung

Die Erfindung betrifft neuartige Bäder zur Erzeugung von Mikrostrukturen, die in vielfältigsten Anwendungsgebieten der Mikrosystemtechnik und der Mikrostrukturierung benötigt werden. Darüber hinaus ermöglichen diese Bäder die Stnikturierung bislang in genannten Anwendungsgebieten unüblicher Schichten oder Schichtsystemen. Besonders vorteilhaft findet die Erfindung Anwendung bei der Strukturierung von Schichtsystemen, deren selektive Strukturierung mit herkömmlichen Ätzmitteln, infolge ihres ähnlichen chemischen Verhaltens problematisch ist und nur mit zusätzlichen aufwendigen Mitteln, wie dem Einbau von Ätzbarrieren o.ä. möglich ist.

Bislang nach dem Stand der Technik in der Mikrostrukturierung eingesetzte Ätz- und Entwicklungsprozesse basieren grundsätzlich auf dem Einsatz gesundheitsschädigender und giftiger Chemikalien, wie z.B. starke Säuren, Laugen und Oxidationsmitteln oder erfordern äußerst kostenaufwendige Prozesse, wie reaktives Ionen- bzw. Plasmaätzen (S. Büttgenbach, Mikromechanik, B. G. Teubner Stuttgart, 1994).

Der Erfindung liegt die Aufgabe zugrunde, neuartige Bäder zur Erzeugung von Mikrostrukturen anzugeben, die eine kostengünstigere und vor allem bei ihrer Entsorgung eine umweltgerechtere Lösung als bekannte Methoden zur Erzeugung von Mikrostrukturen darstellen.

Die Aufgabe wird durch die kennzeichnenden Merkmale des ersten Patentanspruchs gelöst. Vorteilhafte weitere Ausgestaltungen sind durch die nachgeordneten Ansprüche erfaßt.
Der Erfindung liegt die Entdeckung zugrunde, daß im Bereich der Mikrostrukturierung bislang zum Einsatz gelangende, strukturierbare Maskierungsschichten, wie Fotoresistschichten, allein durch ihre Anwesenheit lokal die Eigenschaften von Biopolymerfilmen beeinflussen können. Das Wesen der Erfindung besteht in der zielgerichteten Auswahl und im Einsatz von biogenen Katalysatoren, insbesondere Enzymen für die Mikrostrukturierung von dünnen Schichten bzw. in besonders vorteilhafter Weise von Dünnschichtsystemen.
Wenn im Rahmen der Erfindung von Bädern gesprochen wird, sind darunter sowohl Bäder zu verstehen, die nach herkömmlich bekannten technischen Lösungen als Ätzbäder bezeichnet werden als auch Lösungen, die der Ausbildung einer Strukturierungs- und Maskierungsschicht dienen.

Biopolymere, die bislang im Bereich der Mikrostrukturierung nicht zum Einsatz gelangten, sind grundsätzlich enzymatisch abbaubar, ebenso eine Vielzahl von organischen, anorganischen Schichten und Metallen. Zudem ist eine Vielzahl von Enzymen verfügbar, die unter veränderten Bedingungen ihrer ursprünglichen Funktion entgegengesetzte Reaktionen auszuführen vermögen. So wirken z.B. Lipasen in organischen Lösungsmitteln als Acetylasen.
Enzyme sind unter geeigneten Bedingungen hochspezifische biogene Katalysatoren, die zusätzlich in ihrer Funktion durch spezifische Inhibitoren oder Kompetitoren gehemmt werden können. Enzymatische Reaktionen erfolgen in der Regel bei Raumtemperatur und in milden Pufferlösungen, die umweltfreundlich entsorgt werden können. Die Enzyme selbst sind ihrer Natur entsprechend durchweg biologisch abbaubar. Häufig arbeiten Enzyme in engen Temperaturbereichen. Damit sind Enzyme auch thermisch in ihrer Aktivität regulierbar. Gängige Enzyme lassen sich grundsätzlich thermisch im Bereich von 40 - 120 °C deaktivieren, wobei gewöhnlich eine Erwärmung über 60 °C ausreichend ist. Damit sind die Voraussetzungen gegeben, Lösungen mit ein oder mehreren Zusätzen von Enzymen bzw. biogenen Katalysatoren als "Ätzbäder" in der Mikrostrukturierung einzusetzen.

Die Erfindung soll nachstehend anhand von fünf Ausführungsbeispielen näher erläutert werden.

In einem ersten Ausführungsbeispiel soll ein Doppelschichtsystem aus Biopolymeren, die bislang im Bereich der Mikrosystemtechnik keine Anwendung fanden, welches mit Maskierungsschicht bspw. aus einem Fotoresist versehen ist strukturiert werden. Ohne die Erfindung darauf zu beschränken, soll für das Doppelschichtsystem Gelatine eingesetzt werden. Hierbei wird die Tatsache ausgenutzt, daß unterschiedliche Enzyme häufig in sehr ähnlichen Puffern mit hoher Effizienz und Selektivität funktionieren können. Auf ein Substrat, bspw. einem gereinigten Siliziumwafer, ist dazu eine erste Gelatineschicht mit ca. 200 nm Dicke abgeschieden, die unter Zugabe von Glutardialdehyd vernetzt wird. Darauf wird eine zweite Gelatineschicht abgeschieden, die mit kurzen Oligonukleotiden (z.B. 8mer) versetzt und mit Glutardialdehyd quervernetzt wurde. Die eingesetzten Oligonukleotide weisen eine Sequenz auf, die eine spezifische Schnittstelle für ein Restriktionsenzym enthält (z.B. 5'-GAATTC-3' für EcoRI). Ein Restriktionsenzym der Gruppe II arbeitet in der Regel in Puffern, die Metallionen (z.B. Mg²⁺) in millimolaren Konzentrationen enthalten. Die untere erste Gelatineschicht kann mit einer Protease abgebaut werden (z.B. Protease K). Proteasen werden häufig durch Metallionen in ihrer Funktion gehemmt, aus diesem Grunde enthalten Protease-Puffer häufig EDTA, EGTA und andere Chelatoren, die in Lösungen enthaltene Metallkontaminationen eliminieren sollen.
Die zweite und erste Gelatineschicht sollen nacheinander in einem Schritt abgebaut werden, dies geschieht unter Einsatz einer Pufferlösung bestehend aus 10 mM NaCl, 5 mM MgCl₂, 1% Glycerol. Dabei wird die obere zweite Gelatineschicht durch Einsatz eines Restriktionsenzyms in den durch die Maskierungsschicht freigelegten Gebieten selektiv abgebaut. Ist dieser Abbau, der mikroskopisch verfolgt werden kann, vollständig erfolgt, wird dem eingesetzten Puffer in millimolarer Konzentration ein Chelator (z.B. 10 mM EDTA) zugesetzt, wodurch die erste untere Gelatineschicht selektiv abbaubar ist.
Eine andere Möglichkeit besteht darin, den Chelator bereits in die obere zweite Gelatine-Oligonukleotidschicht bei ihrer Herstellung einzubringen. Dieser Chelator würde dann mit dem fortschreitenden Abbau der Oligonukleotide freigesetzt werden und so die Inaktivierung der Protease durch die im Puffer enthaltenen Metallionen aufheben. Diese wäre dann in der Lage die untere erste Schicht als auch das Restriktionsenzym abzubauen. Die allosterische Regulation der genannten Enzyme durch Metallionen erfolgt entgegengesetzt, was einen sukzessiven Einsatz ermöglicht. Es existieren aber auch Proteasen, die nur unter Einsatz von

Metallen zu funktionieren vermögen, was einen simultanen Einsatz zuließe (z.B. die Familie der Zinkproteasen (z.B. Carboxypeptidase A)). Zudem ist es dem Stand der heutigen biotechnologischen Forschung entsprechend problemlos möglich, metallresistente oder metallsensitive Mutanten der Enzyme zu erhalten.

In einem zweiten, nicht erfindungsgemäßen Ausführungsbeispiel soll die Anwendung eines Bades zur Herstellung einer freitragenden Membran beschrieben werden. Auf einen gereinigten Siliziumwafer ist eine dünne Biopolymerschicht mit einer Schichtdicke von ca. 200 nm durch Aufschleudern aufgebracht. Im Beispiel wird diese Schicht durch in Wasser gelöste 10%ige Gelatine, die mit 5% Glutardialdehyd versetzt wird gebildet. Diese Schicht ist nicht wasserlöslich und gegen übliche Fotolackentwickler resistent. Im Beispiel erfolgt eine anschließende Beschichtung mit einem handelsüblichen Fotoumkehrresist. Die Fotoresistschicht wird nach Vorschrift behandelt, entsprechend der später gewünschten Struktur maskiert, belichtet und strukturiert. Der gesamte Schichtverbund bestehend aus dem Siliziumwafer, der quervernetzten Gelantineschicht und der strukturierten Fotoresistschicht wird in ein enzymatisches Bad eingebracht. Im Falle der Verwendung von Gelatine für die Biopolymerschicht besteht das enzymatische Bad bevorzugt aus einem Protease K - Puffer, der im wesentlichen durch 10% SDS, 10 mM NaCl, 10 mM EDTA und 10 mM Tris-HCl gebildet wird und dem 10 mg/ml Protease K zugegeben sind. Der pH-Wert dieses Bades beträgt 8,5. Unter Einsatz eines solchen enzymatischen Bades erfolgt der vollständige Abbau der ca. 200 nm dicken Gelantineschicht bei Raumtemperatur innerhalb von ca. 8 h. Als Ergebnis des "Ätzprozesses" liegt eine freitragende Fotoresistmembran vor.

In einem dritten Ausführungsbeispiel soll die Wirkung eines Bades gemäß der Erfindung bei Vorsehung einer Abbaustoppschicht (in Analogie zu bisher bekannten Ätzstoppschichten) beschrieben werden.
Soll eine ausgewählte Schicht vor äußeren Einflüssen geschützt werden und gleichzeitig die Möglichkeit bestehen diese Schicht definiert freizulegen, z.B. zur Erzeugung dünner Membranen aus einer bioorganischen Verbindung, was wiederum am Beispiel von Gelatine beschrieben werden soll, so ist dies problemlos möglich, wenn die Gelatineschicht, die später die Membran bildet, zuvor mit Metallen oder spezifischen Inhibitoren des zum Abbau eingesetzten Enzyms dotiert wird. Solche Inhibitoren sind grundsätzlich künstliche Analoga der Übergangszustände des enzymatisch abzubauenden Substrates mit Bindungen, die durch das Enzym nicht spaltbar sind; z.B. Etherbindungen bei Proteasen, die Peptidbindungen spalten. Eine solcherart präparierte Dünnschicht soll mit einer zweiten Dünnschicht aus Agarose mit einer Dicke von ca. 1 µm versehen sein. In die zweite Dünnschicht, die zuvor mit einer entsprechenden Maskierungsschicht versehen wird, wird die gewünschte Ausnehmung unter Einsatz eines Bades bestehend aus 0,1 g/ml Agarase, 5 mM EDTA, 10 mM NaCl und 10 mM Na₂HPO₄ eingebracht. Ist der Abbau soweit fortgeschritten, daß die präparierte erste Dünnschicht erreicht ist, wird die Agarase durch die auf der Oberfläche der ersten Schicht befindlichen Inhibitoren am fortschreitenden Abbau gehindert.

In einem vierten Ausführungsbeispiel erfolgt der Einsatz eines Bades gemäß der Erfindung zur Strukturierung eines Doppelschichtsystems aus Gelatine und Agarose derart, daß dem Bad bestehend aus 5 mM NaCl, 5 mM Na₂HPO₄, 0,1 mg/ml Agarase und 1 mg/ml thermostabile Proteinase, gewonnen aus einem thermophilen Organismus (z.B. Thermus Thermophilus), dem in diesem Fall also zwei Enzyme zugegeben sind. Dabei zeichnet sich die Agarase dadurch aus, daß sie bei Raumtemperatur aktiv ist, bei der die thermostabile Proteinase keine nachweisbare Aktivität zeigt. In diesem ersten Abbauschritt wird ausschließlich die gewünschte Struktur der oberen Schicht bestehend aus Agarose abgetragen. Danach wird die Temperatur des Bades auf **72** °C erhöht und damit die Proteinase aktiviert wird, wohingegen die Agarase keine nachweisbare Aktivität mehr zeigt. Es erfolgt der ausschließliche Abbau der unteren Gelatineschicht des Doppelschichtsystems.

In einem fünften Ausführungsbeispiel soll die Strukturierung eines Dünnschichtsystems aus Eisen-Gelatine-Lipid mittels eines oder mehrerer Bäder gemäß der Erfindung beschrieben werden. Es findet eine Lösung Einsatz, der ein Siderophor, wie Aerobactin oder Enterobactin zu ca. 10 mg/ml zugegeben ist. Nach einer Zeit von ca. 1 h, bei einer Temperatur von 20°C ist die ca. 100 nm dicke Eisenschicht in den unmaskierten Bereichen abgetragen. Die Gelatineschicht ist in der zum zweiten Ausführungsbeispiel beschriebenen Pufferlösung mit einer Proteinase in der durch die erzeugte Fe-Struktur vorgegebenen Maskierung abtragbar, wodurch die Lipidschicht freigelegt ist. Diese Lipidschicht ist durch eine wässrige Lösung bestehend aus 1% Glycerol und 1 mg/ml einer zum Abbau der Lipidschicht geeigneten Lipase strukturierbar.

Die Erfindung ist nicht auf die in den Ausführungsbeispielen angegeben Bäder beschränkt. Die auf eine im konkreten Fall zu strukturierende Dünnschicht erfolgende Auswahl eines speziell zutreffenden biogenen Katalysators, insbesondere eines Enzyms, kann unter Anwendung biotechnologischen Fachwissens ohne weitere erfinderische Tätigkeit erfolgen.

## Patentansprüche

1. Neuartige Bäder zur Erzeugung von Mikrostrukturen in dünnen Schichten auf dem Gebiet der Mikrosystemtechnik und Mikrostrukturierung bestehend aus einer Lösung, der wenigstens ein biogener Katalysator, der auf eine vorgebbare Dünnschicht einwirkt, zugegeben ist, dadurch gekennzeichnet, daß bei gleichzeitiger Zugabe von mehreren biogenen Katalysatoren und/oder Enzymen, deren Auswahl in Abhängigkeit von der Schichtfolge eines zu strukturierenden Schichtsystems derart erfolgt, daß sie durch Zusatz von Inhibitoren oder Kompetitoren jeweils wechselseitig, nacheinander oder zugleich ihre aktive selektive Wirkung entfachen.

2. Neuartige Bäder nach Anspruch 1, dadurch gekennzeichnet, daß die Zugabe der Inhibitoren oder Kompetitoren durch Einbau oder Anlagerung an eine zu strukturierende Dünnschicht erfolgt.

3. Neuartige Bäder nach Anspruch 1 und/oder 2, dadurch gekennzeichnet, daß bei gleichzeitiger Zugabe von mehreren biogenen Katalysatoren und/oder Enzymen, deren Auswahl in Abhängigkeit von der Schichtfolge eines zu strukturierenden Schichtsystems derart erfolgt, daß sie bei voneinander unterschiedlichen Temperaturen ihre aktive selektive Wirkung entfachen.

## Claims

1. Novel baths for generating microstructures in thin layers in the field of microsystem technique and in microstructuring comprising a solution to which is added at least one biogenic catalyst acting upon a preselectable thin layer, characterized in that at a simultaneous addition of a plurality of biogenic catalysts and/or enzymes, the selection of which being in dependence of a layer sequence of a layer system to be structurized in such a manner that by adding inhibitors or competitors their selective action is rendered active in respective alternation subsequently or simultaneously.

2. Novel baths as claimed in claim 1, wherein the addition of inhibitors or competitors is by insertion into or attachment to a thin layer to be structurized.

3. Novel baths as claimed in claim 1 and/or 2, wherein the simultaneous addition of a plurality of biogenic catalysts and/or enzymes, the selection of which being, in dependence of a layer sequence of a layer system to be structurized, in such a manner that their active selective effect is rendered active at temperatures differing from one another.

## Revendications

1. Un nouveau type de bains destinés à produire des microstructures dans des couches minces dans le domaine de la technologie des microsystèmes et de la microstructuration comprenant une solution à laquelle au moins un catalyseur biogène agissant sur une couche mince à déterminer d'avance doit être additionné, est caractérisé en ce que dans le cas de la présence au même moment de plusieurs catalyseurs biogènes et d'enzymes sélectionnés en fonction de la succession des couches dans le système à couches à structurer, le moment précis de l'intervention - soit en alternant, soit consécutivement, soit simultanément - de chacun de ces réactifs peut être déterminé grâce à l'addition d'inhibiteurs ou de compétiteurs appropriés.

2. Les bains d'un nouveau type selon la revendication 1 sont caractérisés en ce que les inhibiteurs ou compétiteurs sont soit intégrés dans la couche mince à structurer soit appliqués à la surface de la couche.

3. Les bains selon les revendications 1 et/ou 2 sont caractérisés en ce que dans le cas de l'addition simultanée de plusieurs catalyseurs biogènes et ou d'enzymes, dont la sélection doit tenir compte de la succession des couches dans le système à structurer, le choix du moment d'intervention d'un réactif donné est déterminé par la température à laquelle le réactif développe son impact sélectif ce qui permet de varier la succession des interventions en fonction de la température.
